# EUROPEAN PATENT APPLICATION

(11) **EP 2 312 638 A1**
(43) Date of publication of application: **20.04.2011**
(21) Application number: 09802864.0
(22) Date of filing: 22.07.2009
(51) Int. Cl.: H01L 29/786, H01L 51/05

(54) **SEMICONDUCTOR DEVICE MANUFACTURING METHOD AND SEMICONDUCTOR DEVICE**

(30) Priority: 30.07.2008 JP 2008195775
(71) Applicant: Sumitomo Chemical Company, Limited, Tokyo 104-8260 (JP)
(72) Inventor: MATSUMURO, Tomonori, Tsukuba-shi Ibaraki 305-0051 (JP)
(74) Representative: Jackson, Martin Peter
(86) International application number: PCT/JP2009/063096
(87) International publication number: WO 2010/013621

(57) **Abstract**

In a method for manufacturing a semiconductor device comprising an n-type transistor (Q1) that has a source electrode (4ns), a drain electrode (4d), an oxide semiconductor film (5), and a gate electrode (2), and that is formed on a substrate (1), and a p-type transistor (Q2) that has a source electrode (4ps), a drain electrode, an organic semiconductor film (7), and a gate electrode, and that is formed on the substrate, the gate electrode is formed on the substrate, the source electrode and the drain electrode are formed, the oxide semiconductor film is formed of an oxide semiconductor material; and the gate electrode is formed on the substrate, the source electrode and the drain electrode are formed, and the organic semiconductor film is formed of an organic semiconductor material.

## Description

### TECHNICAL FIELD

The present invention relates to a method for manufacturing a semiconductor device and a semiconductor device in which a first transistor and a second transistor are formed on a single substrate.

### BACKGROUND ART

Semiconductor devices made of an organic semiconductor material may be manufactured at a lower cost than silicon semiconductor devices, and are capable of realizing large-area and mechanically flexible semiconductor devices. Accordingly, a semiconductor device made of an organic semiconductor material is highly possibly used as a substitute for a silicon semiconductor device depending on the application, and is attracting attention as one of the useful semiconductor devices.

A complementary logic circuit comprising complementary transistors has high energy efficiency and is advantageous in size reduction, and therefore, it is essential in the present integrated circuits. To manufacture a complementary logic circuit at a low cost, a study has been made on complementary transistors formed by a semiconductor device made of an organic semiconductor material. For example, complementary transistors in which channels of an n-type transistor and a p-type transistor are made of an organic semiconductor film have been proposed (see Patent Document 1).

[Patent Document 1] JP 3522771 B
[Patent Document 2] JP 3597468 B
[Patent Document 3] USP 5625199

### DISCLOSURE OF INVENTION

### PROBLEM TO BE SOLVED BY THE INVENTION

However, when a silicon material is used to form one of the channels of the n-type and p-type transistors, a high-temperature process is required to activate the channel, and a sophisticated vacuum process should also be performed for a plurality of times. Accordingly, a complicated process must be performed using a device with a large configuration.

It is an object of the present invention to provide a method for manufacturing a semiconductor device and a semiconductor device capable of easily manufacturing high-performance complementary transistors.

### MEANS FOR SOLVING PROBLEM

For solving the above problem and achieving the above object, the present invention provides the following:
[1] A method for manufacturing a semiconductor device that comprises
   a first transistor that comprises a first source electrode, a first drain electrode, a first semiconductor film, and a first gate electrode, and formed on a substrate, and
   a second transistor that comprises a second source electrode, a second drain electrode, a second semiconductor film, and a second gate electrode electrically connected to the first gate electrode, and formed on the substrate, the method comprising:
      a step of forming a first gate electrode at which the first gate electrode is formed on the substrate;
      a step of forming a first source-drain electrode at which the first source electrode and the first drain electrode are formed;
      a step of forming a first semiconductor film at which the first semiconductor film is formed by using an oxide semiconductor material;
      a step of forming a second gate electrode at which the second gate electrode is formed on the substrate;
      a step of forming a second source-drain electrode at which the second source electrode and the second drain electrode are formed; and
      a step of forming a second semiconductor film at which the second semiconductor film is formed by using an organic semiconductor material.
[2] The method for manufacturing the semiconductor device according to above [1], wherein
   the first semiconductor film is formed by a sputtering method using the oxide semiconductor material at the step of forming the first semiconductor film, and
   the second semiconductor film is formed by a coating method in which the organic semiconductor material is used as an application liquid at the step of forming the second semiconductor film.
[3] The method for manufacturing the semiconductor device according to above [1], wherein
   the first semiconductor film is formed by a coating method in which the oxide semiconductor material is used as an application liquid at the step of forming the first semiconductor film, and
   the second semiconductor film is formed by a coating method in which the organic semiconductor material is used as an application liquid at the step of forming the second semiconductor film.
[4] The method for manufacturing the semiconductor device according to any one of above [1] to [3], wherein
   the first transistor is an n-type transistor, and the second transistor is a p-type transistor.
[5] The method for manufacturing the semiconductor device according to any one of above [1] to [4], wherein the first semiconductor film is formed by using zinc tin oxide as the oxide semiconductor material at the step of forming the first semiconductor film.
[6] The method for manufacturing the semiconductor device according to any one of above [1] to [5], further comprising:
   a step of forming a passivation film at which a passivation film is formed on a surface of at least one or both of the first semiconductor film and the second semiconductor film, wherein
   the passivation film is made of a fluorine resin.
[7] A semiconductor device: comprising a first transistor and a second transistor formed on a single substrate,
   the first transistor comprising
   a first gate electrode,
   a first source electrode,
   a first drain electrode, and
   a first semiconductor film formed between the first source electrode and the first drain electrode and made of an oxide semiconductor, and
   the second transistor comprising
   a second gate electrode electrically connected to the first gate electrode,
   a second source electrode,
   a second drain electrode, and
   a second semiconductor film formed between the second source electrode and the second drain electrode and made of an organic semiconductor.
[8] The semiconductor device according to above [7], wherein the oxide semiconductor is zinc tin oxide.
[9] The semiconductor device according to above [8], further comprising a passivation film formed on a surface of at least one or both of the first semiconductor film and the second semiconductor film , and made of a fluorine resin.

### EFFECT OF THE INVENTION

When the first and second semiconductor films are made of either an oxide semiconductor material or an organic semiconductor material, it is difficult to form n-type and p-type transistors in a manner that the mobility of both transistors satisfies a desired value. In the present invention, by contrast, the first and the second semiconductor films are made of different semiconductor materials of the oxide semiconductor or the organic semiconductor. Accordingly, a combination of the oxide semiconductor material and the organic semiconductor material can be appropriately selected to form the semiconductor films, whereby high-performance complementary transistors can be manufactured. Because the first transistor and the second transistor are made of the oxide semiconductor material and the organic semiconductor material that can be formed by a simple process, instead of a silicon material that requires a complicated process, it is possible to easily manufacture high-performance complementary transistors.

### BRIEF DESCRIPTION OF DRAWINGS

[Fig. 1] Fig. 1 is a circuit diagram of an electrical structure of a semiconductor device comprising complementary transistors according to a first embodiment of the present invention.
[Fig. 2] Fig. 2 is a plan view of the semiconductor device comprising the complementary transistors according to the first embodiment of the present invention.
[Fig. 3] Fig. 3 is a sectional view of the semiconductor device comprising the complementary transistors according to the first embodiment of the present invention.
[Fig. 4-1] Fig. 4-1 is a sectional view of a method for manufacturing the semiconductor device shown in Fig. 3.
[Fig. 4-2] Fig. 4-2 is a sectional view of the method for manufacturing the semiconductor device shown in Fig. 3.
[Fig. 4-3] Fig. 4-3 is a sectional view of the method for manufacturing the semiconductor device shown in Fig. 3.
[Fig. 4-4] Fig. 4-4 is a sectional view of the method for manufacturing the semiconductor device shown in Fig. 3.

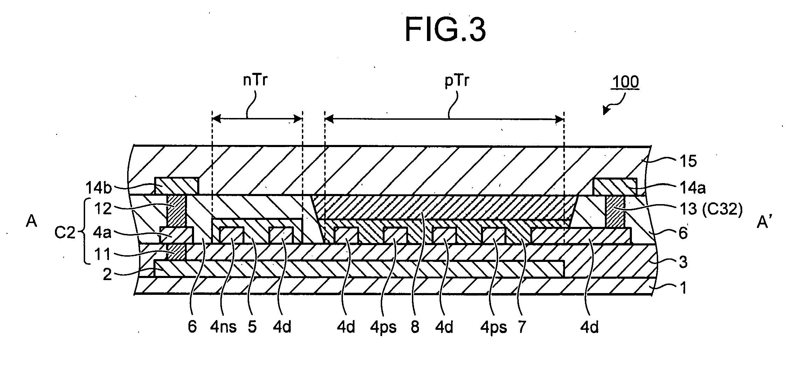

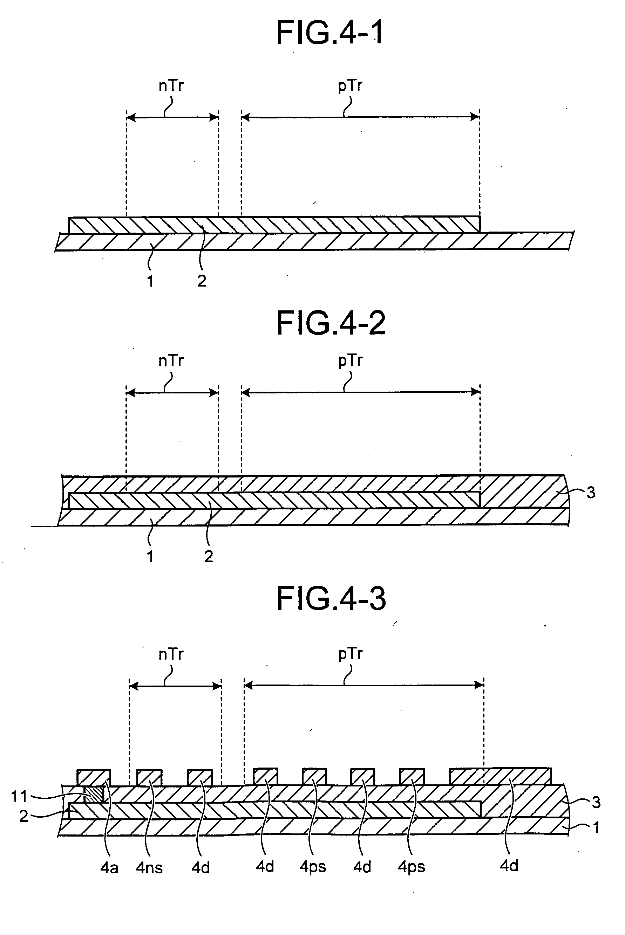

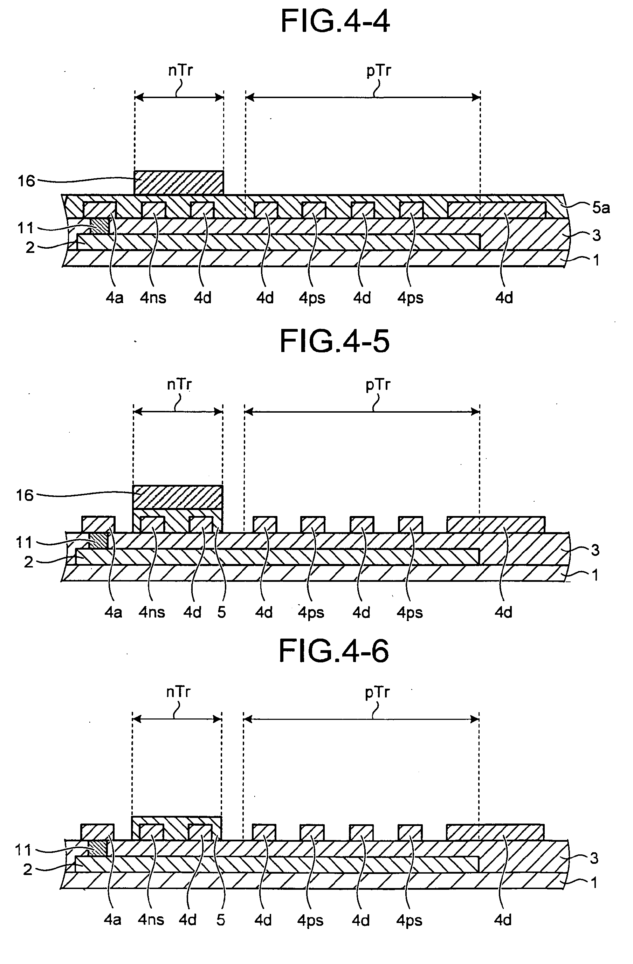

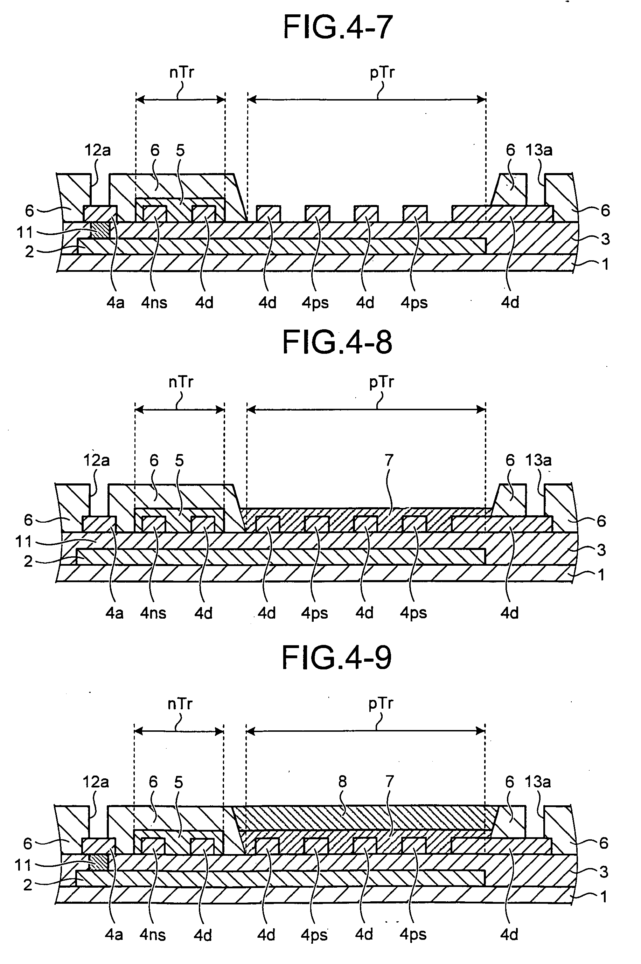

[Fig. 4-5] Fig. 4-5 is a sectional view of the method for manufacturing the semiconductor device shown in Fig. 3.
[Fig. 4-6] Fig. 4-6 is a sectional view of the method for manufacturing the semiconductor device shown in Fig. 3.
[Fig. 4-7] Fig. 4-7 is a sectional view of the method for manufacturing the semiconductor device shown in Fig. 3.
[Fig. 4-8] Fig. 4-8 is a sectional view of the method for manufacturing the semiconductor device shown in Fig. 3.
[Fig. 4-9] Fig. 4-9 is a sectional view of the method for manufacturing the semiconductor device shown in Fig. 3.

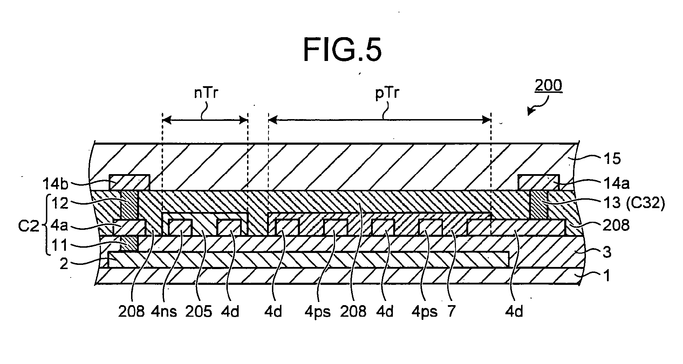

[Fig. 5] Fig. 5 is a sectional view of a semiconductor device comprising complementary transistors according to a second embodiment of the present invention.

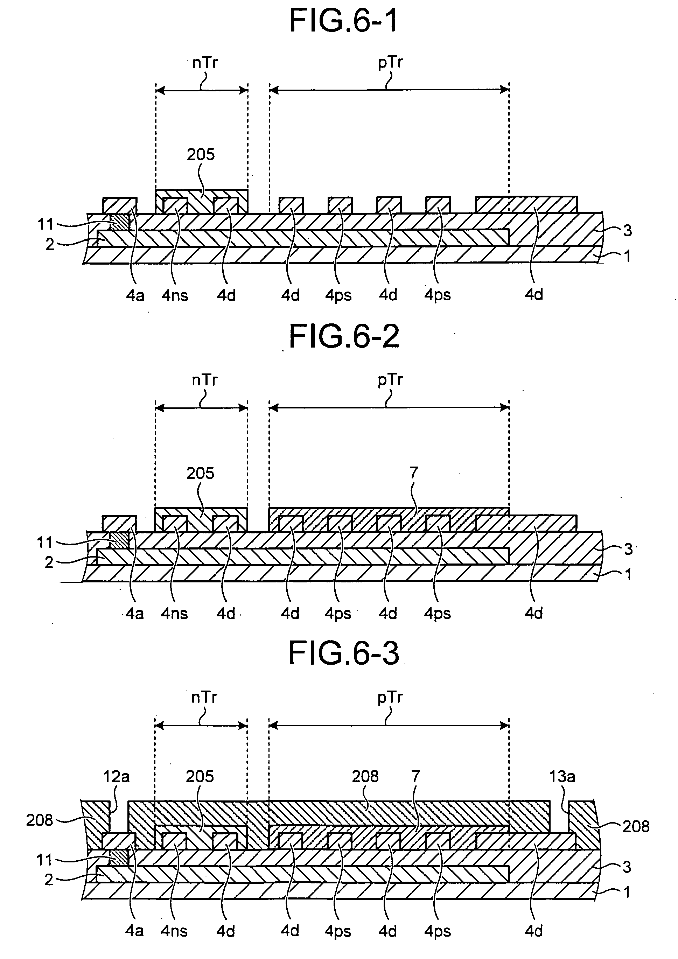

[Fig. 6-1] Fig. 6-1 is a sectional view of a method for manufacturing the semiconductor device shown in Fig. 5.
[Fig. 6-2] Fig. 6-2 is a sectional view of the method for manufacturing the semiconductor device shown in Fig. 5.
[Fig. 6-3] Fig. 6-3 is a sectional view of the method for manufacturing the semiconductor device shown in Fig. 5.

### BEST MODE(S) FOR CARRYING OUT THE INVENTION

Embodiments according to the present invention are described below in greater detail with reference to the accompanying drawings. However, the present invention is not limited to these embodiments. In the drawings, the same portions are denoted by the same reference numerals. The drawings are schematic, and a relationship between the thickness and the width of each layer, and ratios of the respective layers may be different from those of the actual ones. Portions with different relative sizes or ratios may be included between the respective drawings. In each step of the method for manufacturing in the embodiments of the present invention, a baking (heat treatment) process for improving the quality of the formed film and the like are included as necessary after the films are formed. However, to simplify the explanation, descriptions thereof may be omitted below.

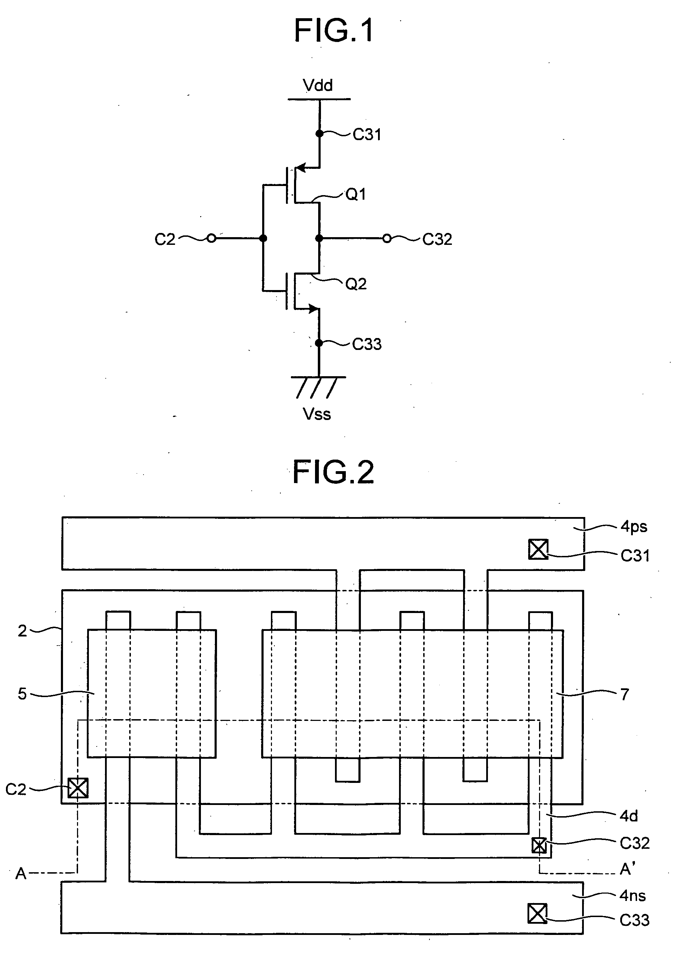

(First Embodiment)
A first embodiment will now be described. Fig. 1 is a circuit diagram of an electrical structure of a semiconductor device comprising complementary transistors according to the first embodiment. Fig. 2 is a plan view of the semiconductor device comprising the complementary transistors according to the first embodiment.

As shown in Fig. 1, the semiconductor device comprises a p-type transistor Q1 and an n-type transistor Q2. The p-type transistor Q1 is a transistor having a p-type (for example, referred to as a first conductivity type) channel, and the n-type transistor Q2 is a transistor having an n-type (for example, referred to as a second conductivity type) channel that is different from the p-type.

In the p-type transistor Q1 and the n-type transistor Q2, each gate (corresponding to a gate electrode 2 in Fig. 2 or Fig. 3) is connected to a contact C2 that is a common wiring at an input side, and each drain (corresponding to a drain electrode 4d in Fig. 2 or Fig. 3) is connected to a contact C32 that is a common wiring at an output side. Accordingly, in the present embodiment, a complementary semiconductor device (such as CMOS transistor) in which a driving transistor is changed depending on the polarity of an input voltage can be realized.

A source (corresponding to a source electrode 4ps in Fig. 2 or Fig. 3) of the p-type transistor Q1 is connected to a power line to which, for example, a power supply voltage Vdd is supplied through a contact C31. A source (corresponding to a source electrode 4ns in Fig. 2 or Fig. 3) of the n-type transistor Q2 is connected to a grounding conductor to which, for example, a ground potential Vss is supplied through a contact C33.

As shown in Fig. 2, in a planar structure of the semiconductor device of the present embodiment, for example, the common gate electrode 2 in a plate shape, the source electrode 4ps of the p-type transistor Q1, the source electrode 4ns of the n-type transistor Q2, the drain electrode 4d of the p-type and n-type transistors Q1 and Q2, an organic semiconductor film 7 having function as a channel of the p-type transistor, and an oxide semiconductor film 5 having function as a channel of the n-type transistor are formed in a region shown in Fig. 2. A part of the common gate electrode 2 functions as a gate for the p-type transistor Q1, and another part of the common gate electrode 2 functions as a gate for the n-type transistor Q2. The source electrode 4ps of the p-type transistor Q1 includes a first wiring portion extending along the gate electrode 2 and being disposed at one side in the short-side direction of the gate electrode 2 in the planar view, and two electrode portions extending from the first wiring portion to a region above the gate electrode 2. The source electrode 4ns of the n-type transistor Q2 comprises a second wiring portion extending along the gate electrode 2 and being disposed at the other side in the short-side direction of the gate electrode 2 in the planar view, and one electrode portion extending from the second wiring portion to the region above the gate electrode 2. The drain electrode 4d of the p-type and n-type transistors Q1 and Q2 comprises a third wiring portion extending along the gate electrode 2 and being disposed between the gate electrode 2 and the second wiring portion in the planar view. The drain electrode 4d also comprises an electrode portion of the n-type transistor Q2 extending from the third wiring portion to the region above the gate electrode 2, and being disposed so as to face the electrode portion of the source electrode 4ns of the n-type transistor Q2. The drain electrode 4d further comprises three electrode portions of the p-type transistor Q1 extending from the third wiring portion to the region above the gate electrode 2, and being disposed between the two electrode portions of the source electrode 4ps of the p-type transistor Q1 and sandwiching the two electrode portions. The contact C31 connected to the source electrode 4ps is connected to a wiring leading to a power source, and the power supply voltage Vdd is supplied to the source electrode 4ps through the contact C31. The contact C32 connected to the drain electrode 4d is connected to a wiring leading to an output mechanism, and an output voltage Vout output from the transistors is supplied to the output mechanism through the contact C32. The contact C33 connected to the source electrode 4ns is connected to a wiring leading to earth. The contact C2 connected to the common gate electrode 2 is connected to a wiring leading to an input mechanism, and an input voltage Vin is supplied to the common gate electrode 2 through the contact C2. In other words, the semiconductor device according to the first embodiment has a structure in which the p-type transistor and the n-type transistor are formed on a single substrate.

The structure of the semiconductor device comprising the complementary transistors according to the first embodiment will now be described. Fig. 3 is a sectional view of the semiconductor device comprising the complementary transistors according to the first embodiment. In Fig. 3, the continuous end facet cut of the layer structure along a line A-A' in Fig. 2 is schematically illustrated. In Fig. 3, for descriptive purposes, the contact C2 connected to the common gate electrode 2 and the contact C32 connected to the drain electrode 4d are also illustrated.

As shown in Fig. 3, a semiconductor device 100 according to the first embodiment comprises a substrate 1 formed of glass, plastic or the like, on which the common gate electrode 2 integrally formed with the gate of the p-type transistor Q1 and the gate of the n-type transistor Q2, a gate insulating film 3 for covering the common gate electrode 2, the source electrode 4ps formed on the gate insulating film 3 and comprising an electrode portion extending into a p-type transistor (Q1) region pTr, the source electrode 4ns formed on the gate insulating film 3 and comprising an electrode portion extending into an n-type transistor (Q2) region nTr, and the drain electrode 4d formed on the gate insulating film 3 and comprising electrode portions extending into the p-type transistor (Q1) region pTr and the n-type transistor (Q2) region nTr are formed.

In the n-type transistor (Q2) region nTr, the oxide semiconductor film 5 having function as a channel of the n-type transistor is formed in a region above the gate insulating film 3 at least sandwiched between the source electrode 4ns and the drain electrode 4d. The oxide semiconductor film 5 is made of zinc tin oxide (ZTO) that is an oxide semiconductor capable of realizing high electron mobility. The ZTO is ZnO-SnO₂, in other words, an oxide of zinc and tin. However, the material for the oxide semiconductor film 5 is not limited to ZTO, but may be any material as long as it is a semiconductor material capable of realizing high electron mobility. The oxide semiconductor film 5 may be opaque or transparent, and whether the oxide semiconductor film 5 is a transparent film or an opaque film is selected depending on the intended use of the semiconductor device. For example, a semiconductor film made of an inorganic oxide such as ZTO may be a film transparent to visible light based on the composition or the fabrication conditions. By forming the oxide semiconductor film 5 using such a transparent inorganic oxide semiconductor, it is possible to form a transparent semiconductor element. More specifically, if the oxide semiconductor film 5 is formed by a sputtering method, the oxide semiconductor film 5 may be formed into a transparent film or an opaque film by adjusting the oxygen concentration in the atmosphere and the substrate temperature. An opaque oxide semiconductor film 5 may be formed by injecting a predetermined impurity into the composition of the sputter target.

In the p-type transistor (Q1) region pTr, the organic semiconductor film 7 having function as a channel of the p-type transistor is formed in a region above the gate insulating film 3 at least sandwiched between the source electrodes 4ps and the drain electrodes 4d. The organic semiconductor film 7 may be formed of any material as long as it is an organic semiconductor capable of realizing high Hall mobility of 1cm²/Vs or more. For example, the organic semiconductor film 7 is formed of an organic semiconductor having a precursor of pentacene or tetrabenzoporphyrin. The organic semiconductor film 7, for example, may be transparent or translucent, and a transparent semiconductor element can be manufactured by forming the organic semiconductor film 7 using a transparent organic semiconductor material.

An interlayer film 6 made of a photosensitive resin is formed on the oxide semiconductor film 5 in a region other than where the organic semiconductor film 7 is formed. A passivation film 8 made of a fluorine resin material is formed on the organic semiconductor film 7.
The fluorine resin material has high solvent selectivity towards the organic semiconductor film 7. The fluorine resin material is soluble in a fluorine solvent in which the components of the organic semiconductor film 7 are insoluble. The fluorine resin material does not practically react with the components of the organic semiconductor film 7. Accordingly, the passivation film 8 can stably protect the organic semiconductor film 7 without damaging the organic semiconductor film 7.

In the semiconductor device 100, a contact 13 (corresponding to the contact C32 in Fig. 2) is formed in the interlayer film 6 between the drain electrode 4d and a wiring layer 14a leading to the output device so as to connect the drain electrode 4d with the wiring layer 14a. A contact (corresponding to the contact C33 in Fig. 2) for connecting the source electrode 4ns with a wiring layer, which is not illustrated, leading to the grounding conductor, for example, is formed between the source electrode 4ns and the wiring layer. A contact (corresponding to the contact C31 in Fig. 2) for connecting the source electrode 4ps with a wiring layer, which is not illustrated, leading to the power source, for example, is formed between the source electrode 4ps and the wiring layer.

In the semiconductor device 100, to connect the common gate electrode 2 with a wiring layer 14b leading to the input device, a contact 11 in the gate insulating film 3, a connection layer 4a formed on the same layer on which the source electrodes 4ns and 4ps and the drain electrode 4d are formed, and a contact 12 in the interlayer film 6 are disposed at a position overlapping with the wiring layer 14b in the planar view. In other words, the contact C2 shown in Fig. 2 comprises the contact 11, the connection layer 4a, and the contact 12 in Fig. 3. In the semiconductor device 100, a passivation film 15 that covers the whole from one side in the thickness direction of the substrate 1 is formed to protect the transistors and the wiring layers 14a and 14b.

In this manner, in the semiconductor device 100 according to the first embodiment, a semiconductor film made of the oxide semiconductor capable of obtaining high electron mobility is used to form the channel of the n-type transistor, and a semiconductor film made of the organic semiconductor capable of obtaining high Hall mobility is used to form the channel of the p-type transistor. Accordingly, it is possible to realize a high-performance semiconductor device capable of operating stably as a complementary logic circuit, while obtaining desired mobility of the n-type and p-type transistors.

A method for manufacturing the semiconductor device 100 according to the present embodiment will now be described. Figs. 4-1 to 4-9 are sectional views of the method for manufacturing the semiconductor device 100 shown in Fig. 3. In Figs. 4-1 to 4-9, sectional views corresponding to the line A-A' in Fig. 3 are shown.

In the present embodiment, a metal film or an oxide conductive film made of chromium (Cr), molybdenum (Mo), Aluminum Niobium (AlNb), Indium-Tin-Oxide (ITO), ZTO, or the like is formed directly above the substrate 1 to form the common gate electrode 2 by using the sputtering method, a vacuum deposition method, a coating method, or the like. Subsequently, as shown in Fig. 4-1, the common gate electrode 2 is patterned by using a photolithography method (in the specification, the "photolithography method" may comprise a patterning process such as an etching process). The number of masks may be reduced by forming the common gate electrode 2 using an ink-jet printing method, a printing method, or the like. The substrate 1 may be any substrate having an electric insulating property, and is made of glass, plastic, or the like. The substrate 1 may also be a so-called flexible substrate having flexibility. The substrate 1 does not need to be transparent.

As shown in Fig. 4-2, the gate insulating film 3 is formed of a material such as a photosensitive resin. The gate insulating film 3 is formed of a material having a permittivity of 1.5 or more, or preferably having a permittivity of 3.5 or more. To realize a desired switching speed, the gate insulating film 3 is preferably formed to a thickness of 500 nanometers or less. It is also preferable that the gate insulating film 3 be sufficiently cross-linked, and that the flatness of one nanometer or less be maintained. The gate insulating film 3 is formed by using a method corresponding to the material such as a spin-coating method.

A contact hole is formed in the gate insulating film 3 by using the photolithography method, for example, on the common gate electrode 2. A conductive material is then filled into the contact hole. A metal film, an oxide conductive film, or a nitride conductive film having high conductivity and greater work function made of ITO, ZTO, Au, Mo, Cu, Al, Ag, MoO₃, MoN, TiN, or the like is formed on the entire surface by using the vacuum deposition method, the sputtering method, the coating method, or the like, to form the source electrodes 4ns and 4ps, the drain electrode 4d, and the connection layer 4a. In this manner, the conductive material is further filled into the contact hole, thereby forming the contact 11 shown in Fig. 4-3. The source electrodes 4ns and 4ps, the drain electrode 4d, and the connection layer 4a are then patterned by using the photolithography method, the etching method, and the like. Accordingly, it is possible to simplify the manufacturing process by collectively forming the contact 11, the source electrodes 4ns and 4ps, the drain electrode 4d, and the connection layer 4a. It is also possible to reduce the number of masks by forming the source electrodes 4ns and 4ps, the drain electrode 4d, and the connection layer 4a using the ink-jet printing method, the printing method, or the like. A process of forming the contact 11 shown in Fig. 4-3 may be provided separately from the process of forming the source electrodes 4ns and 4ps, the drain electrode 4d, and the connection layer 4a by filling a conductive material into the contact hole.

As shown in Fig. 4-4, an oxide semiconductor layer 5a made of ZTO or the like is formed on the entire surfaces of the source electrodes 4ns and 4ps, the drain electrode 4d, the connection layer 4a, and the gate insulating film 3. The oxide semiconductor layer 5a is formed by the sputtering method. A photoresist thin film 16 is formed on a region where the oxide semiconductor film 5 is formed by spin-coating with the photoresist, and then performing exposure and development processes. By etching the oxide semiconductor layer 5a using the photoresist thin film 16 as a mask, as shown in Fig. 4-5, the oxide semiconductor film 5 having function as a channel of the n-type transistor is patterned between the source electrode 4ns and the drain electrode 4d of the n-type transistor. Subsequently, as shown in Fig. 4-6, the photoresist thin film 16 is removed.

Exposure and development processes are then performed after forming a photosensitive resin film on the entire surface. Accordingly, as shown in Fig. 4-7, the interlayer film 6 in which an opening to expose the p-type transistor region pTr, a contact hole 12a to expose at least a part of the connection layer 4a, and a contact hole 13a to expose at least a part of the drain electrode 4d are fabricated is formed. The interlayer film 6 is formed to a thickness of, for example, one micrometer.

The organic semiconductor film 7 is then formed by a coating method in which an organic semiconductor material is used as an application liquid. The organic semiconductor material is in a liquid form, and comprises a material to be the organic semiconductor film 7 and a solvent or a disperse medium for dissolving or dispersing the material. The liquid form is in a state of solution, in a state of dispersion liquid, or in a state of sol. In the present embodiment, the organic semiconductor film 7 is formed by applying an organic semiconductor material in the state of solution as an application liquid. When the organic semiconductor film 7 is formed by the coating method, the organic semiconductor film 7 is likely to be formed in a lyophilic region. Accordingly, to form the organic semiconductor film 7 only in the p-type transistor region pTr, a liquid-repellent treatment is applied to the interlayer film 6, and as shown in Fig. 4-8, a liquid organic semiconductor material is supplied to an opening region of the interlayer film 6, in other words, to the p-type transistor region pTr. As a result, the organic semiconductor film 7 having function as a channel of the p-type transistor can be appropriately formed between the source electrode 4ps and the drain electrode 4d of the p-type transistor. The organic semiconductor film 7 is formed of a semiconductor material or the like having a precursor of pentacene or tetrabenzoporphyrin. The organic semiconductor film 7 is formed by using the ink-jet printing method, the printing method, or the like. The thickness of the organic semiconductor film 7 is, for example, from 50 to 70 nanometers. When the opening region of the interlayer film 6 is subjected to lyophilic treatment as well as the liquid-repellent treatment is applied to the interlayer film 6, the organic semiconductor film 7 can be selectively formed by using the spin-coating method.

As shown in Fig. 4-9, the passivation film 8 is formed on the organic semiconductor film 7 by using the coating method such as the ink-jet printing method and the printing method. The passivation film 8 is made of fluorine resin having a thickness of, for example, from 500 nanometers to one micrometer. As described above, the passivation film 8 is formed by the coating method using the application liquid comprising fluorine solvent and fluorine resin that do not practically dissolve the organic semiconductor film 7, thereby preventing the organic semiconductor film 7 from being damaged while the passivation film 8 is formed. It is possible to stably protect the organic semiconductor film 7 because the passivation film 8 does not practically react with the organic semiconductor film 7. It is also possible to reduce the damage caused to the organic semiconductor film 7 while the passivation film 8 is formed because the passivation film 8 is formed by using the coating method such as the ink-jet printing method and the printing method, instead of the photolithography method.

The contacts 12 and 13 shown in Fig. 3 are formed by filling a conductive material into the contact holes 12a and 13a formed in the interlayer film 6. A metal film or the like is formed over the passivation film 8 and the contacts 12 and 13 by using the vacuum deposition method, the sputtering method, and the coating method to form the wiring layers 14a and 14b. The wiring layers 14a and 14b are then patterned by using the photolithography method. By forming the passivation film 15 on the entire surface, it is possible to obtain the semiconductor device 100 shown in Fig. 3. As described above, the contacts 12 and 13 and the wiring layers 14a and 14b may be collectively formed in the same process. The wiring layers 14a and 14b may also be formed by using the ink-jet printing method, the printing method, or the like.

In this manner, in the semiconductor device 100 according to the first embodiment, a semiconductor layer (corresponding to the oxide semiconductor film 5) that is a channel layer of the n-type transistor is formed of an oxide semiconductor material capable of forming a semiconductor film that can obtain high electron mobility, instead of using a silicon material. A semiconductor layer (corresponding to the organic semiconductor film 7) that is a channel layer of the p-type transistor is formed of an organic semiconductor material capable of forming a semiconductor film that can obtain high Hall mobility. Accordingly, the first embodiment requires no carrier doping, no high-temperature process for activating the channel, or strict vacuum process is not always necessary. Consequently, it is possible to manufacture high-performance complementary transistors capable of operating stably as a complementary logic circuit without using a device with a large configuration, in a simple process, and while obtaining desired mobility of the n-type and p-type transistors.

The semiconductor device 100 according to the first embodiment requires no high-temperature process for activating the channel. Accordingly, there is no need to limit the type of the substrate 1, and the substrate 1 of various materials can be selected.

(Second Embodiment)
A second embodiment will now be described. In the second embodiment, the semiconductor device is more easily manufactured by forming a channel of the n-type transistor using a coating method in which an oxide semiconductor material in a sol state is used as an application liquid. More specifically, the channel of the n-type transistor is formed by using a so-called sol-gel method in which an oxide semiconductor material in a sol state is applied to a predetermined position and the material is then converted into a gel state.

Fig. 5 is a sectional view of a semiconductor device comprising complementary transistors according to the second embodiment. In Fig. 5, for descriptive purposes, the contact connected to the common gate electrode 2, and the contact connected to the source electrodes 4ns and 4ps, and the contact connected to the drain electrode 4d are also illustrated. The semiconductor device according to the second embodiment has the planar structure similar to the planar view, for example, illustrated in Fig. 2.

As shown in Fig. 5, in a semiconductor device 200 according to the second embodiment, a channel of the n-type transistor is made of an oxide semiconductor film 205 formed by using the sol-gel method instead of the oxide semiconductor film 5 shown in Fig. 3. The sol-gel method described here is a method of obtaining an oxide semiconductor by hydrolyzing dispersion liquid (in a sol state) in which an oxide semiconductor material in a fine particle state is dispersed, forming the liquid into an assembly (in a gel state) of fine particles without fluidity by polycondensation reaction, and heating the assembly. The oxide semiconductor film 205, for example, may be transparent or translucent. For example, a transparent semiconductor element can be fabricated by forming the oxide semiconductor film 205 using an oxide semiconductor material in which nanoparticles made of ZTO are dispersed in a disperse medium. The film quality of the oxide semiconductor film 205 can be improved by baking the formed film after applying the oxide semiconductor material. However, in the following explanation, the descriptions thereof are omitted for simplicity.

A passivation film 208 made of the same material is formed on the oxide semiconductor film 205 and the organic semiconductor film 7. The passivation film 208, similar to the passivation film 8 shown in Fig. 3, is made of a fluorine resin material having high solvent selectivity towards the organic semiconductor film 7. The fluorine resin material also does not practically react with the components of the oxide semiconductor film 205. Accordingly, it is possible to stably protect the oxide semiconductor film 205 without damaging the oxide semiconductor film 205.

In this manner, in the semiconductor device 200 according to the second embodiment, an oxide semiconductor material capable of forming a semiconductor film that can obtain high electron mobility is used to form a semiconductor layer (corresponding to the oxide semiconductor film 205) that is a channel layer of the n-type transistor, and an organic semiconductor material capable of forming a semiconductor film that can obtain high Hall mobility is used to form a semiconductor layer (corresponding to the organic semiconductor film 7) that is a channel layer of the p-type transistor. Accordingly, it is possible to realize high-performance complementary transistors capable of operating stably as a complementary logic circuit, while obtaining desired mobility of the n-type and p-type transistors.

A method for manufacturing the semiconductor device 200 shown in Fig. 5 will now be described. Figs. 6-1 to 6-3 are sectional views of the method for manufacturing the semiconductor device 200 shown in Fig. 5. Similar to those shown in Figs. 4-1 to 4-3, the common gate electrode 2, the gate insulating film 3, the source electrodes 4ns and 4ps, the drain electrode 4d, and the connection layer 4a are formed on the substrate 1. Subsequently, as shown in Fig. 6-1, the oxide semiconductor film 205 is formed in the n-type transistor region nTr by using the sol-gel method. The oxide semiconductor film 205 is formed by the application using the printing method.
The oxide semiconductor film 205 may also be formed by using a film made of an oxide semiconductor obtained by using the coating method such as the spin-coating method and the ink-jet printing method, as well as the printing method.

As shown in Fig. 6-2, the organic semiconductor film 7 is formed in the p-type transistor region pTr by using an organic semiconductor material. The organic semiconductor film 7 is formed by using the printing method. The organic semiconductor film 7 may also be formed by using a film made of an organic semiconductor obtained by using the coating method such as the spin-coating method and the ink-jet printing method. As shown in Fig. 6-3, a fluorine resin material is then applied over the source electrodes 4ns and 4ps, the drain electrode 4d, the connection layer 4a, the oxide semiconductor film 205, and the organic semiconductor film 7, and patterned by the photolithography method. Accordingly, the passivation film 208 in which the contact holes 12a and 13a are formed is formed over the connection layer 4a, the predetermined source electrodes 4ns and 4ps, and the drain electrode 4d. Similar to the semiconductor device 100 according to the first embodiment, the contacts 12 and 13 shown in Fig. 5 are then formed by filling a conductive material into the contact holes 12a and 13a. The wiring layers 14a and 14b are then patterned. The passivation film 15 is then formed on the entire surface. In this manner, the semiconductor device 200 shown in Fig. 5 is formed.

In this manner, in the second embodiment, instead of using a silicon material, a channel of the n-type transistor is made of an oxide semiconductor material capable of forming a semiconductor film that can obtain high electron mobility, and a channel of the p-type transistor is made of an organic semiconductor material capable of forming a semiconductor film that can obtain high Hall mobility. Accordingly, similarly to the first embodiment, no carrier doping, no high-temperature process for activating a channel, and no sophisticated vacuum process are required. Consequently, it is possible to manufacture high-performance complementary transistors capable of operating stably as a complementary logic circuit without using a device with a large configuration, in a simple process, and while obtaining desired mobility of the n-type and p-type transistors.

In the second embodiment, the oxide semiconductor film 205 is formed by applying an oxide semiconductor material in a sol state to a predetermined position by the printing method or the like, changing the material into a gel state, and heating the material. Accordingly, in the second embodiment, it is possible to omit the photolithography process and the etching process required for forming the oxide semiconductor film 5 in the first embodiment. Consequently, it is possible to manufacture high-performance complementary transistors in a simpler process than that of the first embodiment.

In the second embodiment, the organic semiconductor film 7 that is a channel of the p-type transistor and the oxide semiconductor film 205 that is a channel of the n-type transistor are formed by the printing method, and the passivation film 208 of the same material is then formed on the entire surface of the substrate 1. Accordingly, in the second embodiment, the interlayer film 6 having an opening region and the passivation film 8 need not be formed separately for each of the transistor regions as in the first embodiment. Consequently, it is possible to manufacture high-performance complementary transistors in a simpler process than that of the first embodiment.

In the second embodiment, the passivation film 208 is formed of a fluorine resin material that does not practically react with the oxide semiconductor film 205 and the organic semiconductor film 7, thereby stably protecting both the oxide semiconductor film 205 and the organic semiconductor film 7. Accordingly, it is possible to appropriately maintain the performance of the complementary transistors.

In the second embodiment, if the films from the common gate electrode 2 to the passivation film 208 are formed by using a coating method such as the ink-jet printing method and the printing method, all the layers to the passivation film 208 can be advantageously formed by a simple coating process, and the number of masks can be reduced.

In the first or the second embodiment, examples are explained in which the semiconductor layer (oxide semiconductor film 5 or 205) that is a channel layer of the n-type transistor is made of an oxide semiconductor material, and the semiconductor layer (organic semiconductor film 7) that is a channel layer of the p-type transistor is made of an organic semiconductor material. However, it is also possible to form the semiconductor layer that is a channel layer of the n-type transistor by using an organic semiconductor material, and form the semiconductor layer that is a channel layer of the p-type transistor by using an oxide semiconductor material. This example requires no high-temperature process or no sophisticated vacuum process similarly to the first and the second embodiments. Accordingly, it is possible to manufacture complementary transistors in a simple process.

In the embodiments described above, the drain electrodes of the p-type transistor Q1 and the n-type transistor Q2 are formed of the same material and in the same process. However, the drain electrodes may be formed of different materials and in different processes. The gate electrodes of the p-type transistor Q1 and n-type transistor Q2 may also be formed of different materials and in different processes. In the embodiments described above, the gate of the p-type transistor Q1 and the gate of the n-type transistor Q2 are integrally formed. However, the gate of the p-type transistor Q1 and the gate of the n-type transistor Q2 may be formed separately, and the gate of the p-type transistor Q1 and the gate of the n-type transistor Q2 may be connected with a wiring. The gate of the p-type transistor Q1 and the gate of the n-type transistor Q2 may also be formed of different materials.

### EXPLANATIONS OF LETTERS OR NUMERALS

- 1: substrate
- 2: common gate electrode
- 3: gate insulating film
- 4a: connection layer
- 4d: drain electrode
- 4ns,: 4ps source electrode
- 5, 205: oxide semiconductor film
- 6: interlayer film
- 7: organic semiconductor film
- 8, 208: passivation film
- 11, 12, 13: contact
- 14a,: 14b wiring layer
- 15: passivation film
- 16: photoresist thin film
- 100, 200: semiconductor device

## Claims

1. A method for manufacturing a semiconductor device that comprises
a first transistor that comprises a first source electrode, a first drain electrode, a first semiconductor film, and a first gate electrode, and that is formed on a substrate, and
a second transistor that comprises a second source electrode, a second drain electrode, a second semiconductor film, and a second gate electrode electrically connected to the first gate electrode, and that is formed on the substrate, the method comprising:
a step of forming a first gate electrode at which the first gate electrode is formed on the substrate;
a step of forming a first source-drain electrode at which the first source electrode and the first drain electrode are formed;
a step of forming a first semiconductor film at which the first semiconductor film is formed by using an oxide semiconductor material;
a step of forming a second gate electrode at which the second gate electrode is formed on the substrate;
a step of forming a second source-drain electrode at which the second source electrode and the second drain electrode are formed; and
a step of forming a second semiconductor film at which the second semiconductor film is formed by using an organic semiconductor material.

2. The method for manufacturing the semiconductor device according to claim 1, wherein
the first semiconductor film is formed by a sputtering method using the oxide semiconductor material at the step of forming the first semiconductor film, and
the second semiconductor film is formed by a coating method in which the organic semiconductor material is used as an application liquid at the step of forming the second semiconductor film.

3. The method for manufacturing the semiconductor device according to claim 1, wherein
the first semiconductor film is formed by a coating method in which the oxide semiconductor material is used as an application liquid at the step of forming the first semiconductor film, and
the second semiconductor film is formed by a coating method in which the organic semiconductor material is used as an application liquid at the step of forming the second semiconductor film.

4. The method for manufacturing the semiconductor device according to claim 1, wherein
the first transistor is an n-type transistor, and
the second transistor is a p-type transistor.

5. The method for manufacturing the semiconductor device according to claim 1, wherein the first semiconductor film is formed by using zinc tin oxide as the oxide semiconductor material at the step of forming the first semiconductor film.

6. The method for manufacturing the semiconductor device according to claim 1, further comprising:
a step of forming a passivation film at which a passivation film is formed on a surface of at least one or both of the first semiconductor film and the second semiconductor film, wherein
the passivation film is made of a fluorine resin.

7. A semiconductor device: comprising a first transistor and a second transistor formed on a single substrate,
the first transistor comprising
a first gate electrode,
a first source electrode,
a first drain electrode, and
a first semiconductor film formed between the first source electrode and the first drain electrode and made of an oxide semiconductor, and
the second transistor comprising
a second gate electrode electrically connected to the first gate electrode,
a second source electrode,
a second drain electrode, and
a second semiconductor film formed between the second source electrode and the second drain electrode and made of an organic semiconductor.

8. The semiconductor device according to claim 7, wherein the oxide semiconductor is zinc tin oxide.

9. The semiconductor device according to claim 8, further comprising a passivation film formed on a surface of at least one or both of the first semiconductor film and the second semiconductor film, and made of a fluorine resin.
